# EUROPEAN PATENT APPLICATION

(11) **EP 4 787 617 A1**
(43) Date of publication of application: **05.08.2026**
(21) Application number: 24886424.1
(22) Date of filing: 30.10.2024
(51) Int. Cl.: H01Q 1/24, H01Q 1/02, H05K 7/20, H05K 1/02, H04M 1/02

(54) **ANTENNA STRUCTURE AND ELECTRONIC DEVICE COMPRISING SAME**

(30) Priority: 30.10.2023 KR 20230146492; 11.12.2023 KR 20230179061
(71) Applicant: Samsung Electronics Co., Ltd., Suwon-si, Gyeonggi-do 16677 (KR)
(72) Inventor: YOO, Jangsun, Suwon-si Gyeonggi-do 16677 (KR); KIM, Hakjin, Suwon-si Gyeonggi-do 16677 (KR); MOON, Jihye, Suwon-si Gyeonggi-do 16677 (KR); SONG, Youngheon, Suwon-si Gyeonggi-do 16677 (KR); LEE, Myeonggil, Suwon-si Gyeonggi-do 16677 (KR); LIM, Gun, Suwon-si Gyeonggi-do 16677 (KR); JO, Gwanghyun, Suwon-si Gyeonggi-do 16677 (KR)
(74) Representative: Gulde & Partner
(86) International application number: PCT/KR2024/096429
(87) International publication number: WO 2025/095754

(57) **Abstract**

An electronic device according to one embodiment of the present disclosure may comprise: a first housing including at least one first conductive portion segmented along at least a portion of the side surface thereof; an antenna carrier having a first antenna pattern electrically connected to the first conductive portion; a fan arranged in the first housing; and a first printed circuit board which is arranged in the first housing and which includes a first communication module electrically connected to the first conductive portion. The antenna carrier can include: a first vent hole formed in at least a portion of the side surface thereof; and a feeding part which is provided on the first antenna pattern and which is electrically connected to the first printed circuit board.

## Description

### [Technical Field]

An embodiment disclosed herein relates to an antenna structure and an electronic device including the same.

### [Background Art]

Due to the remarkable development of information communication technology and semiconductor technology, the distribution and use of various electronic devices are rapidly increasing. Recent electronic devices are being developed to be portable and capable of communication.

The term "electronic device" may refer to a device that performs a specific function according to an installed program, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be now equipped with various functions. For example, in addition to communication functions, entertainment functions such as games, multimedia functions such as music and video playback, communication and security functions such as mobile banking, and functions such as schedule management and electronic wallet are being integrated into a single electronic device. Such an electronic device is being miniaturized so as to be conveniently carried by users.

As mobile communication services extend to a multimedia service field, users have become able to use multimedia services as well as voice calls or short messages through an electronic device. In order to allow users to use multimedia services without inconvenience, electronic devices are increasingly being equipped with display panels having larger sizes. In recent years, foldable electronic devices in each of which a flexible display panel is disposed have been disclosed.

The above-described information may be provided as related art for the purpose of helping to understand the disclosure. No claim or determination is made as to whether any of the foregoing may be applied as prior art with respect to the disclosure.

### [Detailed Description of the Invention]

### [Technical Solution]

According to an embodiment of the disclosure, an electronic device may include a first housing including at least one first conductive portion segmented along at least a portion of a side surface, an antenna carrier on which a first antenna pattern electrically connected to the first conductive portion is formed, a fan disposed in the first housing, and a first printed circuit board disposed in the first housing and including a first communication module electrically connected to the first conductive portion. The antenna carrier may include a first vent hole formed in at least a portion of a side surface, and a feeding portion provided on the first antenna pattern and configured to be electrically connected to the first printed circuit board.

According to an embodiment of the disclosure, an electronic device may include a first housing including at least one first conductive portion segmented along at least a portion of a side surface, an antenna carrier on which a first antenna pattern electrically connected to the first conductive portion via a coupling member is formed, a fan disposed in the first housing, and a first printed circuit board disposed in the first housing and including a first communication module electrically connected to the first conductive portion. The antenna carrier may include a first vent hole formed in at least a portion of a side surface.

### [Brief Description of Drawings]

FIG. 1 is a block diagram of an electronic device in a network environment, according to an embodiment.
FIG. 2 is a view illustrating a front surface of an electronic device in an unfolded state, according to an embodiment of the disclosure.
FIG. 3 is a view illustrating a rear surface and side surfaces of the electronic device in the unfolded state, according to an embodiment of the disclosure.
FIG. 4 is a view illustrating a rear surface of the electronic device according to an embodiment of the disclosure.
FIG. 5 is a view illustrating an interior of an electronic device in the unfolded state, according to an embodiment of the disclosure.
FIG. 6 is a view illustrating an antenna structure according to an embodiment of the disclosure.
FIG. 7 is a cross-sectional view illustrating the antenna structure of FIG. 6 taken along line A-A', according to an embodiment of the disclosure.
FIG. 8 is a view illustrating an antenna structure including a feeding portion and a ground portion, according to an embodiment of the disclosure.
FIG. 9 is a view illustrating an antenna structure including a feeding portion and a ground portion, according to an embodiment of the disclosure.
FIG. 10 is a view illustrating an antenna structure including a feeding portion, according to an embodiment of the disclosure.
FIG. 11 is a view illustrating a housing and an antenna structure according to an embodiment of the disclosure.
FIG. 12 is a front view illustrating an antenna structure of a first housing, according to an embodiment of the disclosure.
FIG. 13 is a view illustrating a first communication module of an electronic device, according to an embodiment of the disclosure.
FIG. 14 is a view illustrating the first communication module disposed in the electronic device, according to an embodiment of the disclosure.
FIG. 15A is a view illustrating a housing in which second vent holes are formed, according to an embodiment of the disclosure.
FIG. 15B is a view illustrating an antenna carrier in which first vent holes are formed, according to an embodiment of the disclosure.
FIG. 16 is a view illustrating an antenna structure including a metal wall, according to an embodiment of the disclosure.

### [Mode for Carrying out the Invention]

The electronic device according to embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to an embodiment, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

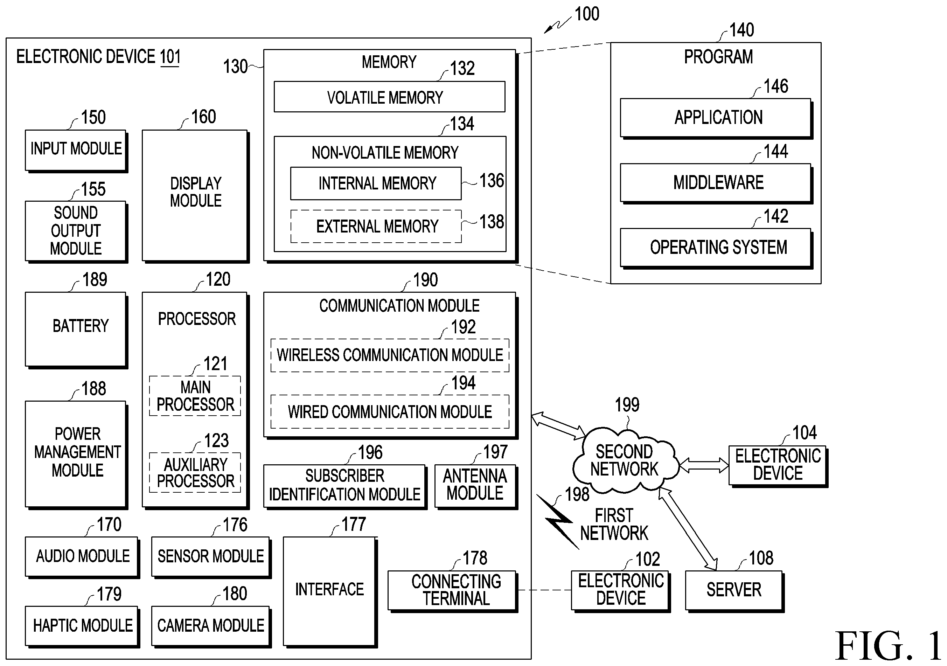

FIG. 1 is a block diagram illustrating an electronic device 101 in a network environment 100 according to an embodiment of the disclosure.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

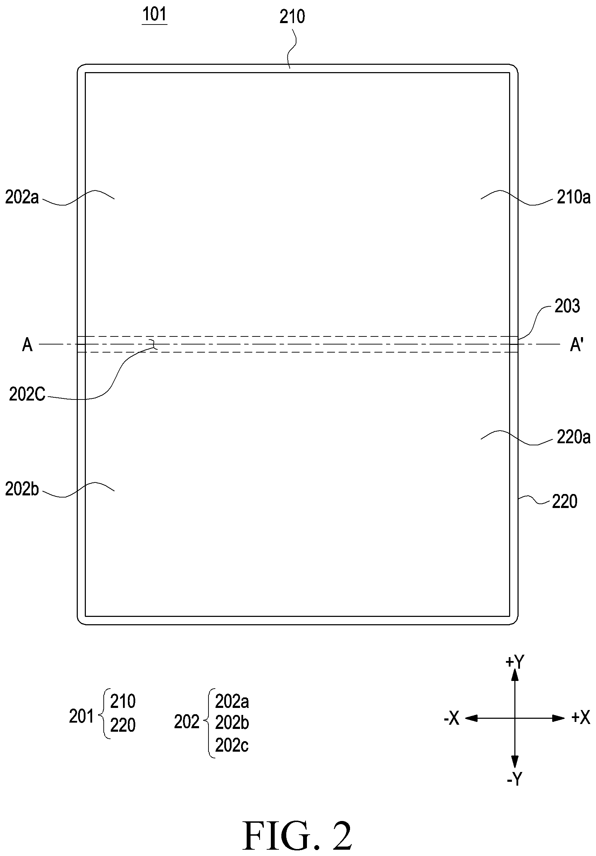

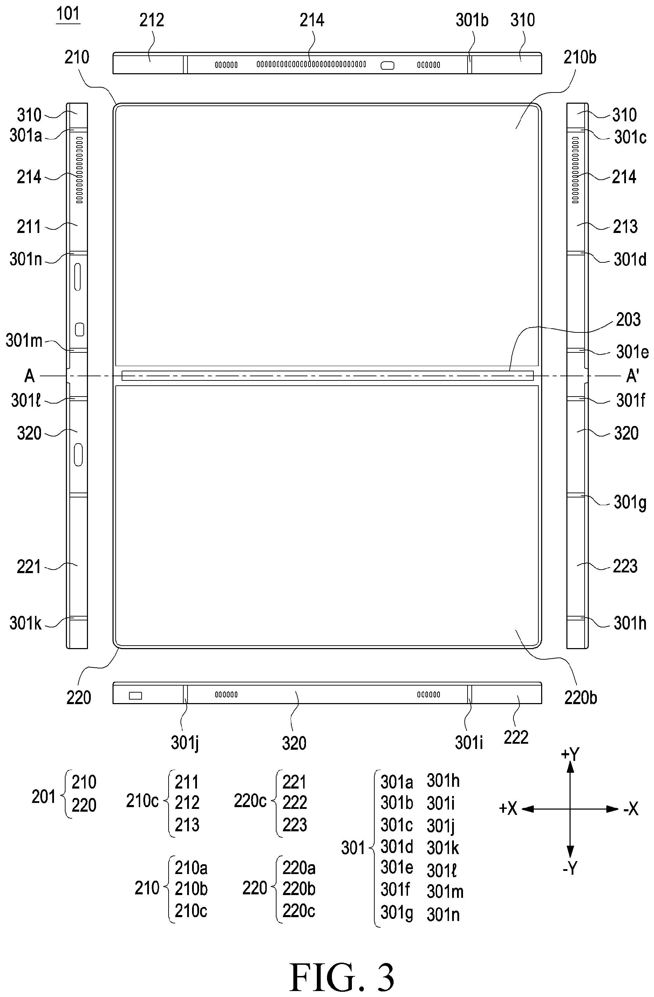

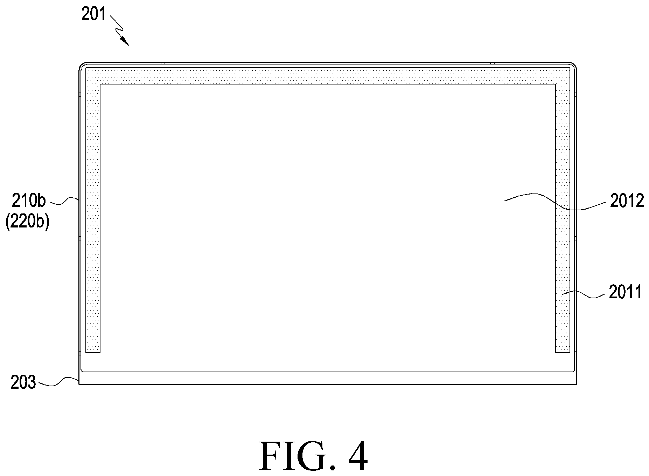

FIG. 2 is a view illustrating a front surface of an electronic device 101 in an unfolded state, according to an embodiment of the disclosure. FIG. 3 is a view illustrating a rear surface and side surfaces of the electronic device 101 in the unfolded state, according to an embodiment of the disclosure. FIG. 4 is a view illustrating a rear surface of the electronic device 101 according to an embodiment of the disclosure.

Referring to FIGS. 2 and 3, the electronic device 101 may include a foldable housing 201 (hereinafter, referred to as a "housing 201") configured to accommodate components of the electronic device 101, and a flexible or foldable display 202 (hereinafter, referred to as a "display 202") disposed in a space formed by the housing 201. The electronic device 101 may further include an antenna structure, and at least one component (e.g., a conductive portion) of the antenna structure may be positioned in one region of the housing 201. The electronic device 101 may further include various components disposed in the housing 201 (e.g., a printed circuit board, a camera module, and a battery).

According to an embodiment, the housing 201 may include a first housing 210 and a second housing 220. According to an embodiment, the first housing 210 and/or the second housing 220 may form at least a part of the external appearance of the electronic device 101. According to an embodiment, a surface on which the display 202 is visually exposed may be defined as a front surface of the electronic device 101 and/or the housing 201 (e.g., a first front surface 210a and a second front surface 220a). In addition, a surface opposite to the front surface may be defined as a rear surface of the electronic device 101 and/or the housing 201 (e.g., a first rear surface 210b and a second rear surface 220b). In addition, a surface surrounding at least a portion of a space between the front surface and the rear surface may be defined as a side surface of the electronic device 101 (e.g., a first side surface 210c and a second side surface 220c).

According to an embodiment, the first side surface 210c of the first housing 210 may include a (1-1)^{th} side surface 211, a (1-2)^{th} side surface 212 extending from the (1-1)^{th} side surface 211 and disposed in a direction perpendicular to the (1-1)^{th} side surface 211, and a (1-3)^{th} side surface 213 extending from the (1-2)^{th} side surface 212 and disposed in the same direction as the (1-1)^{th} side surface 211. According to an embodiment, the second side surface 220c of the second housing 220 may include a (2-1)^{th} side surface 221, a (2-2)^{th} side surface 222 extending from the (2-1)^{th} side surface 221 and disposed in a direction perpendicular to the (2-1)^{th} side surface 221, and a (2-3)^{th} side surface 223 extending from the (2-2)^{th} side surface 222 and disposed in the same direction as the (2-1)^{th} side surface 221.

According to an embodiment, in order to improve aesthetics of the electronic device 101 and to reduce the thickness of the electronic device 101 in the folded state, at least a portion of the first housing 210 and/or the second housing 220 may be formed of a metal material.

According to an embodiment, the first housing 210 may include at least one first conductive portion 310 segmented along at least a portion of the first side surface 210c. For example, the first conductive portion 310 may be a frame formed of a metal material of the first housing 210 and may be utilized as a radiator of an antenna. In an embodiment, in order for the first conductive portion 310 to be utilized as a radiator of an antenna, one end of the first conductive portion 310 may be segmented (e.g., a segmented portion 301). However, the segmented portion 301 corresponds to one example, and the segmented portion 301 may be variously modified in design depending on a frequency utilization range of the antenna.

According to an embodiment, the second housing 220 may include a second conductive portion 320 segmented along at least a portion of the second side surface 220c. For example, the second conductive portion 320 may be a frame formed of a metal material of the second housing 220 and may be utilized as a radiator of an antenna. In an embodiment, in order for the second conductive portion 320 to be utilized as a radiator of an antenna, one end of the second conductive portion 320 may be segmented (e.g., a segmented portion 301). However, the segmented portion 301 corresponds to one example, and the segmented portion 301 may be variously modified in design depending on the frequency utilization range of the antenna.

According to an embodiment, the first housing 210 and/or the second housing 220 may include a second vent hole 214 formed in at least a portion of a side surface (e.g., the first side surface 210c and the second side surface 220c). The second vent hole 214 may be formed in a housing 210 or 220 in which a fan is disposed. For example, when a fan is disposed inside the first housing 210, the second vent hole 214 may be formed in at least a portion of the first side surface 210c of the first housing 210. According to an embodiment, a plurality of second vent holes 214 may be formed.

According to an embodiment, a rear surface of the housing 201 (e.g., the first rear surface 210b and the second rear surface 220b) may include a material that does not interfere with antenna radiation. For example, the first rear surface 210b and the second rear surface 220b may include glass or an injection-molded material. According to an embodiment, the rear surface of the housing 201 (e.g., the first rear surface 210b and the second rear surface 220b) may be formed of a metal material at least in part in order to improve aesthetics of the electronic device 101 and to reduce the thickness of the electronic device 101 in the folded state. According to an embodiment, referring to FIG. 4, the rear surface of the housing (e.g., the first rear surface 210b and the second rear surface 220b) may include a first region 2011 including a non-metal material for antenna radiation, and a second region 2012 including a metal material as a region other than the first region 2011. The first region 2011 may include a region that is in contact with a side surface of the housing (e.g., the first side surface 210c and the second side surface 220c) in a vertical direction. The first region 2011 may be an edge region that affects antenna radiation. The second region 2012 may extend from the first region 2011 and may refer to a region excluding the first region 2011. The second region 2012 may be a central region.

According to an embodiment, the first housing 210 may be rotatably connected to the second housing 220 via a hinge module 203. For example, the first housing 210 and the second housing 220 may each be rotatably connected to the hinge module 203. Accordingly, the electronic device 101 may be transitioned to a folded state (not illustrated) or an unfolded state (e.g., FIGS. 2 and 3). When the electronic device 101 is in the folded state, the first front surface 210a may face the second front surface 220a, and in the unfolded state, a direction in which the first front surface 210a is oriented may be the same as a direction in which the second front surface 220a is oriented. For example, in the unfolded state, the first front surface 210a may be located on substantially the same plane as the second front surface 220a. According to an embodiment, the second housing 220 may move relative to the first housing 210.

According to an embodiment, the first housing 210 and the second housing 220 may be disposed on opposite sides about the folding axis A and may have generally symmetrical shapes with respect to the folding axis A. As will be described later, the angle between the first housing 210 and the second housing 220 may be changed depending on whether the electronic device 101 is in an unfolded state, a folded state, or an intermediate state between the unfolded state and the folded state.

According to an embodiment, the display 202 may refer to a display, at least a portion of which is transformable into a planar surface or a curved surface. For example, the display 202 may be configured to vary in response to the relative movement of the second housing 220 with respect to the first housing 210. According to an embodiment, the display 202 may include a folding region 202c, a first display region 202a disposed on one side of the folding region 202c (e.g., above the folding region 202c illustrated in FIG. 2 (in the +Y direction)), and a second display region 202b disposed on the other side of the folding region 202c (e.g., below the folding region 202c illustrated in FIG. 2 (in the -Y direction)). According to an embodiment, the folding region 202c may be positioned above the hinge module 203. According to an embodiment, the first display region 202a may be disposed on the first housing 210, and the second display region 202b may be disposed on the second housing 220. According to an embodiment, the display 202 may be accommodated in the first housing 210 and the second housing 220.

However, the region division of the display 202 illustrated in FIG. 2 is exemplary, and the display 202 may be divided into multiple (e.g., four or more or two) regions depending on its structure or function. For example, in the embodiment illustrated in FIG. 2, regions of the display 202 may be divided by the folding region 202c extending parallel to the X-axis or by a folding axis (A-axis). However, in an embodiment, the display 202 may be divided into regions with reference to another folding region (e.g., a folding region extending parallel to the Y-axis) or another folding axis (e.g., a folding axis extending parallel to the Y-axis). According to an embodiment, the display 202 may be coupled to or disposed adjacent to a touch detection circuit, a pressure sensor that is capable of measuring touch intensity (pressure), and/or a digitizer configured to detect a magnetic field-type stylus pen.

According to an embodiment, at least a portion of the display 202 may include a metal material such as a metal mesh for a touch operation. According to an embodiment, an edge portion of the display 202 may include a non-metal material for antenna radiation. According to an embodiment, the display 202 may include a first region (not illustrated) including a non-metal material for antenna radiation, and a second region (not illustrated) including a metal material as a region other than the first region (not illustrated). The first region may include a region that is in contact with a side surface of the housing (e.g., the first side surface 210c and the second side surface 220c) in a vertical direction. The first region may be an edge region that affects antenna radiation. The second region may extend from the first region and may refer to a region other than the first region. The second region may be a central region.

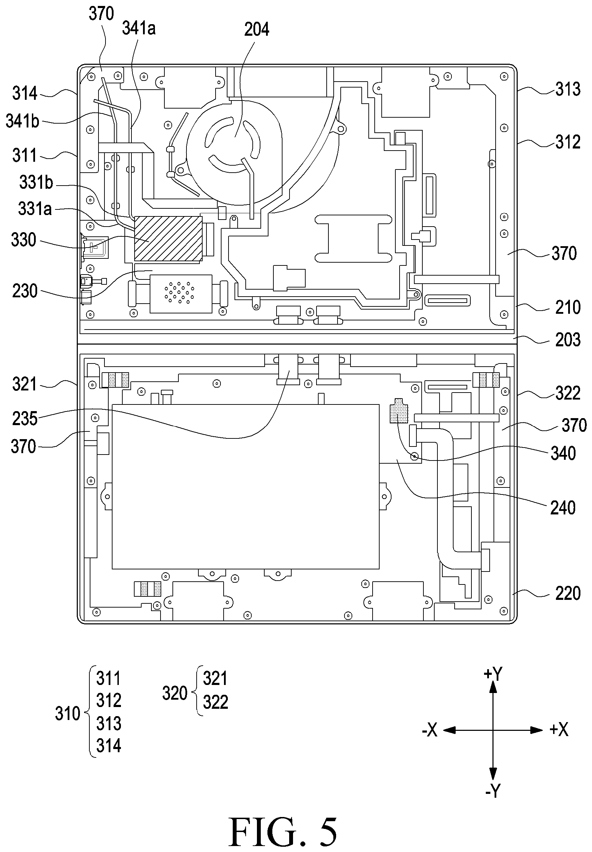

FIG. 5 is a view illustrating an interior of an electronic device 101 in the unfolded state, according to an embodiment of the disclosure.

Referring to FIG. 5, an electronic device 101 may include a foldable housing 201 (hereinafter, referred to as a "housing 201") configured to accommodate components of the electronic device 101, a flexible or foldable display 202 (hereinafter, referred to as a "display 202") disposed in a space formed by the housing 201, a fan 204, and printed circuit boards 230 and 240. The electronic device 101 may further include an antenna structure, and at least one component of the antenna structure (e.g., a conductive portion) may be formed in one region of the housing 201. The electronic device 101 may further include various components disposed in the housing 201 (e.g., a printed circuit board, a camera module, and a battery).

Hereinafter, an antenna structure of the first housing 210 will be described. The antenna structure of the second housing 220 may be applied in the same manner as the antenna structure of the first housing 210.

According to an embodiment, the electronic device 101 may include an antenna structure, and the antenna structure may include a plurality of antennas. For example, the antenna structure may include a conductive portion (e.g., a first conductive portion 310) and an antenna carrier 370. In an embodiment, the antenna structure may be disposed in an edge portion of the first housing 210. For example, the antenna structure may be formed in a left (-X-axis direction) portion and/or a right (+X-axis direction) portion of the first housing 210. Considering the overall structure and shape of the housing 201, an available area may be larger when the antenna structure is disposed in the left (-X-axis direction) portion and/or the right (+X-axis direction) portion than when the antenna structure is disposed in an upper (+Y-axis direction) portion or a lower (-Y-axis direction) portion. However, the disclosure is not limited to the above-described embodiment, and depending on a size and a structure of the electronic device, an upper or lower arrangement may also be possible.

According to an embodiment, a conductive portion (e.g., an antenna pattern) may include at least a portion of the first housing 210 (e.g., the first side surface 210c) formed of a conductive material. For example, the first housing 210 may include a first conductive portion 310 formed at least partially of a metal material, and non-conductive portions (hereinafter, referred to as segmentation portions 301) disposed adjacent to respective conductive portions. At least a portion of the first conductive portion 310 may operate as an antenna pattern. According to an embodiment, the first conductive portion 310 may include a (1-1)^{th} conductive portion 311, a (1-2)^{th} conductive portion 312, a (1-3)^{th} conductive portion 313, and a (1-4)^{th} conductive portion 314.

According to an embodiment, the segmentation portions 301 may be non-conductive portions and may provide dielectric properties different from those of the first conductive portion 310. For example, the segmentation portions 301 may be filled with an insulating material for insulation, and may include any insulating material including, but not limited to, an elastomer material, ceramic, mica, glass, plastic, a metal oxide, air, and/or another material having higher insulating properties than metal.

According to an embodiment, at least a portion of a (1-1)^{th} side surface 211 of the first housing 210 and/or a (1-2)^{th}side surface 212 extending from the (1-1)^{th} side surface 211 may operate as a radiator of an antenna. For example, at least a portion of the (1-1)^{th} side surface 211 and/or the (1-2)^{th} side surface 212 may protect components disposed inside the electronic device 101 and may provide a function of operating as an antenna. Conductive portions 311 and 314 of the (1-1)^{th} side surface 211 and/or the (1-2)^{th} side surface 212 operating as an antenna may be electrically connected to a wireless communication circuit (e.g., the wireless communication module 192 of FIG. 1) so as to transmit and/or receive a radio frequency (RF) signal. For example, the (1-1)^{th} side surface 211 may include a (1-1)^{th} conductive portion 311, and a remaining portion of the (1-1)^{th} side surface 211 and/or a portion of the (1-2)^{th} side surface 212 may include a (1-4)^{th} conductive portion 314. Segmentation portions 301 (e.g., the segmentation portions 301a to 301n of FIG. 3) may be positioned at opposite ends of the (1-1)^{th} conductive portion 311 and the (1-4)^{th} conductive portion 314. A segmentation portion 301 may be positioned between the (1-1)^{th} conductive portion 311 and the (1-4)^{th} conductive portion 314.

According to an embodiment, at least a portion of the (1-3)^{th} side surface 213 of the first housing 210 and/or the (1-2)^{th} side surface 212 extending from the (1-3)^{th} side surface 213 may operate as a radiator of an antenna. For example, at least a portion of the (1-3)^{th} side surface 213 and/or the (1-2)^{th} side surface 212 may protect components disposed inside the electronic device 101 and may provide a function of operating as an antenna. Conductive portions 313 and 312 of the (1-3)^{th} side surface 213 and/or the (1-2)^{th} side surface 212 operating as an antenna may be electrically connected to a wireless communication circuit (e.g., the wireless communication module 192 of FIG. 1) so as to transmit and/or receive a radio frequency (RF) signal. For example, the (1-3)^{th}side surface 213 may include a (1-2)^{th} conductive portion 312, and a remaining portion of the (1-3)^{th} side surface 213 and/or a portion of the (1-2)^{th} side surface 212 may include a (1-3)^{th} conductive portion 313. A segmentation portion 301 may be positioned between the (1-3)^{th} conductive portion 313 and the (1-2)^{th} conductive portion 312. Segmentation portions 301 may be positioned at opposite ends of the (1-3)^{th}conductive portion 313 and the (1-2)^{th} conductive portion 312.

According to an embodiment, the antenna carrier 370 may be coupled to the first conductive portion 310. The antenna carrier 370 may be an assembly bracket for coupling to a rear surface of the housing (e.g., the first rear surface 210b and the second rear surface 220b) and may operate as a radiator of an antenna together with the first conductive portion 310. The configuration of the antenna carrier 370 and a coupling relationship thereof will be described later in detail.

According to an embodiment, a fan 204, which is a heat dissipation device, may be disposed inside the first housing 210 or the second housing 220. Since the electronic device 101 according to the disclosure is a high-performance electronic device that uses power of 10 W or more, the fan 204 may be disposed in the electronic device 101 for heat dissipation performance of the electronic device 101. According to an embodiment, the fan 204 may be disposed in a central portion inside a housing (e.g., the first housing 210 or the second housing 220). For example, the fan 204 may be disposed in a central portion of the first housing 210 so as to draw external air into the interior of the first housing 210 and dissipate heat generated in the electronic device 101. When the fan 204 is driven, the fan 204 may control heat generation of the electronic device 101 by drawing air from the outside and supplying the drawn air into the interior of the first housing 210. According to an embodiment, air introduced into the interior of the first housing 210 through the fan 204 may receive heat from the electronic device 101 and may be discharged through the second vent hole 214 formed in at least a portion of the first side surface 210c of the first housing 210. The fan 204 may control heat generation of the electronic device 101 by supplying external air into the interior of the first housing 210. In addition, conversely, heat generation of the electronic device 101 may be controlled by discharging air inside the first housing 210 to the outside. For example, heat generated from heat sources disposed on a printed circuit board or internal components of the electronic device 101 such as the display may accumulate inside the first housing 210, and the heated air inside the first housing 210 may be discharged to the outside from the interior of the first housing 210 by driving the fan 204, thereby dissipating heat. According to an embodiment, when air inside the first housing 210 is discharged to the outside, a heat transfer member (not illustrated) configured to transfer heat to the inside of the first housing 210, specifically, heat transfer members containing carbon, such as a graphite sheet or graphene, metal members such as a copper sheet or an aluminum sheet, or heat transfer members using a catalyst such as a heat pipe may be mounted. However, the position where the fan 204 is disposed is not limited, and when the fan 204 is disposed in the second housing 220, a vent hole (e.g., the second vent hole 214 of FIG. 3) may be formed in a second side surface (e.g., the second side surface 220c of FIG. 3) of the second housing 220.

According to an embodiment, the first printed circuit board 230 disposed in the first housing 210 and the second printed circuit board 240 disposed in the second housing 220 may have a processor, memory, communication modules 330 and 340, and/or an interface mounted thereon. The processor may include, for example, one or more of a central processing unit, an application processor, a graphics processing unit, an image signal processor, a sensor hub processor, or a communication processor. The memory may include volatile memory or non-volatile memory. The interface may include, for example, a high-definition multimedia interface (HDMI), a universal serial bus (USB) interface, an SD card interface, and/or an audio interface. The interface may electrically or physically connect, for example, the electronic device 101 to an external electronic device 101 and may include a USB connector, an SD card/an MMC connector, or an audio connector.

According to an embodiment, the flexible printed circuit board 235 may electrically connect a component positioned in the first housing 210 (e.g., the first printed circuit board 230) and a component positioned in the second housing 220 (e.g., the second printed circuit board 240). According to an embodiment, the flexible printed circuit board 235 may extend across the hinge module 203. For example, a portion of the flexible printed circuit board 235 may be disposed within the first housing 210 and another portion may be disposed within the second housing 220.

According to an embodiment, the electronic device 101 may include a plurality of communication modules (e.g., 330 and 340) to support a plurality of different wireless access technologies. According to an embodiment, the first printed circuit board 230 may be disposed on one side within the first housing 210 and may include a first communication module 330 electrically connected to the first conductive portion 310, and the second printed circuit board 240 may be disposed on one side within the second housing 220 and may include a second communication module 340 electrically connected to the second conductive portion 320. For example, the first communication module 330 and the second communication module 340 may support different networks. For example, the first communication module 330 may be a 5G wireless communication module, and the second communication module 340 may be a Wi-Fi module. The 5G wireless communication module may transmit and receive 5G signals to and from a 5G base station through a 5G mobile communication network. However, types of the first communication module 330 and the second communication module 340 are not limited, and the first communication module 330 may be a Wi-Fi module while the second communication module 340 may be a 5G wireless communication module. According to an embodiment, when the electronic device 101 has a sufficiently large size, both the first communication module 330 and the second communication module 340 may be disposed in the first housing 210 or the second housing 220 (not illustrated).

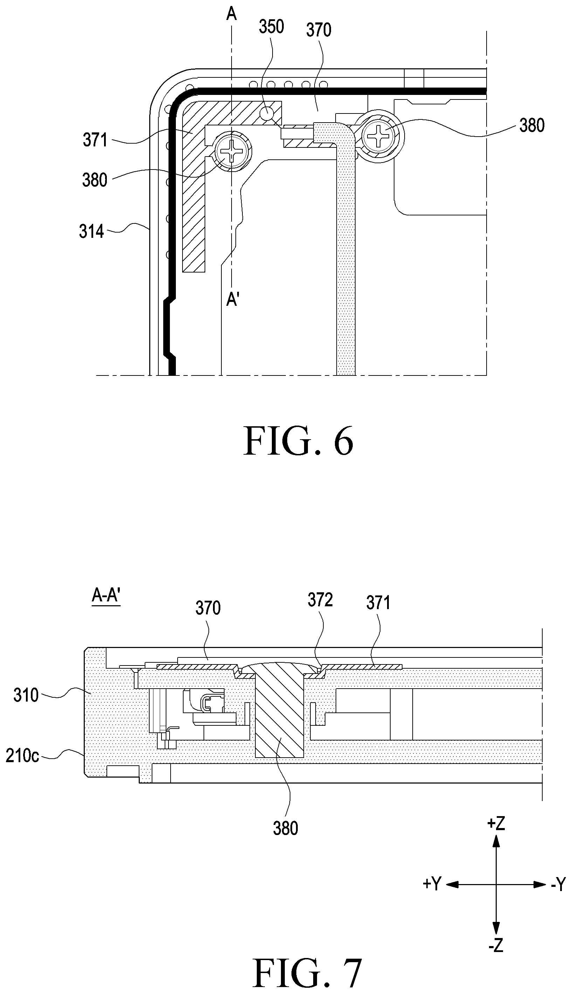

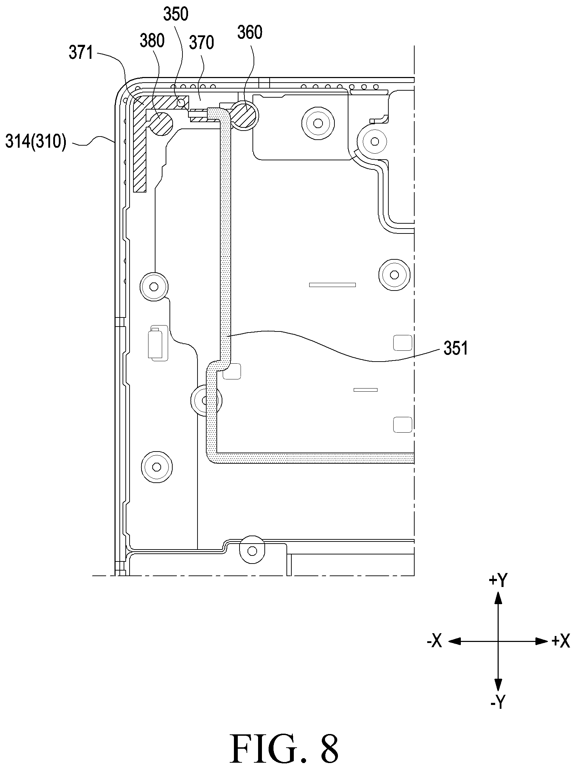

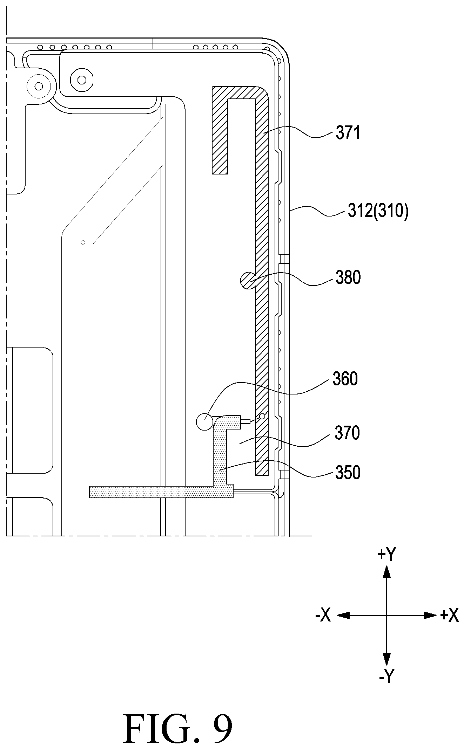

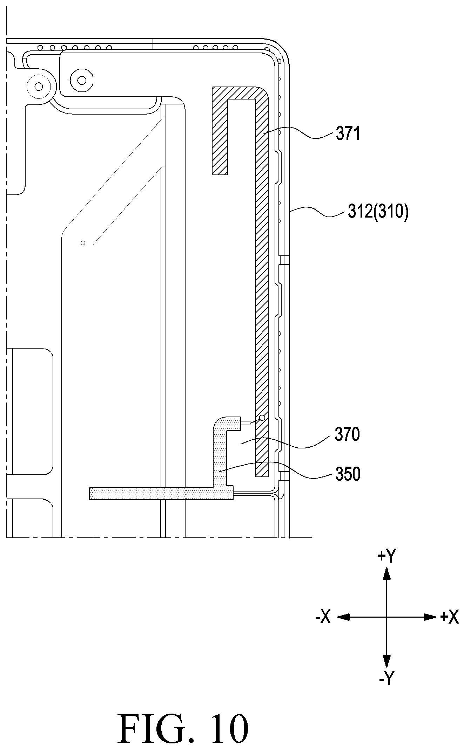

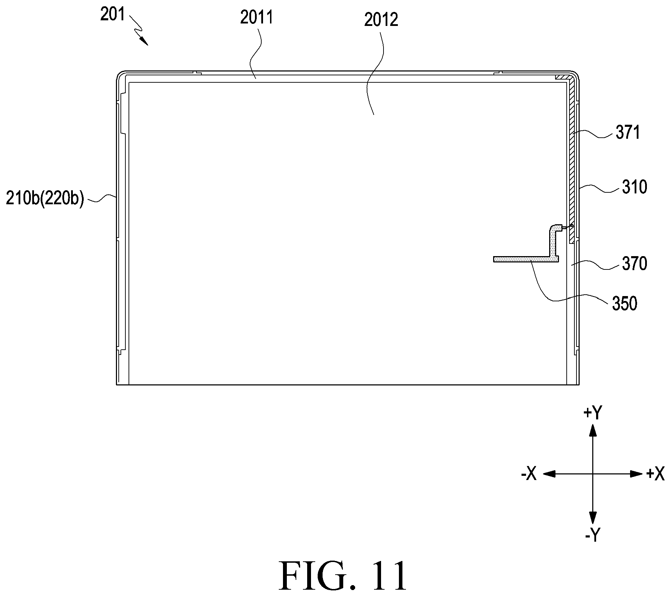

FIG. 6 is a view illustrating an antenna structure according to an embodiment of the disclosure. FIG. 7 is a cross-sectional view illustrating the antenna structure of FIG. 6 taken along line A-A', according to an embodiment of the disclosure. FIG. 8 is a view illustrating an antenna structure including a feeding portion and a ground portion, according to an embodiment of the disclosure. FIG. 9 is a view illustrating an antenna structure including a feeding portion and a ground portion, according to an embodiment of the disclosure. FIG. 10 is a view illustrating an antenna structure including a feeding portion, according to an embodiment of the disclosure. FIG. 11 is a view illustrating a housing and an antenna structure according to an embodiment of the disclosure.

Referring to FIGS. 6 to 11, the electronic device 101 may include a foldable housing 201 (hereinafter, referred to as a "housing 201") configured to accommodate components of the electronic device 101, a flexible or foldable display 202 (hereinafter, referred to as a "display 202") disposed in a space formed by the housing 201, a fan 204, and printed circuit boards 230 and 240. The electronic device 101 may further include an antenna structure, and at least one component (e.g., a conductive portion) of the antenna structure may be positioned in one region of the housing 201. The electronic device 101 may further include various components disposed in the housing 201 (e.g., a printed circuit board, a camera module, and a battery).

According to an embodiment, the antenna carrier 370 may be coupled to the first conductive portion 310. According to an embodiment, the antenna carrier 370 may be coupled to the first conductive portion 310 to form a single antenna band. According to an embodiment, the antenna carrier 370 may include a first antenna pattern 371 electrically connected to the first conductive portion 310. According to an embodiment, the antenna carrier 370 may be designed as a single pattern by being coupled to the first conductive portion 310. The antenna carrier 370 may be an assembly bracket for coupling to a rear surface of the housing (e.g., the first rear surface 210b and the second rear surface 220b) and may operate as a radiator of an antenna together with the first conductive portion 310.

According to an embodiment, the antenna carrier 370 may be electrically connected to the first conductive portion 310 via a coupling member 380. For example, the coupling member 380 may be a member such as a screw or a hook. According to an embodiment, at least one hole 372 may be formed in the first antenna pattern 371 formed on the antenna carrier 370. A side surface 210c of a housing including the first conductive portion 310 may extend toward an inner portion of the electronic device 101 and may be arranged to overlap the first antenna pattern 371 in the Z-axis direction. The coupling member 380 may be disposed through the at least one hole 372 formed in the first antenna pattern 371 and may be in contact with at least a portion of the housing 201 extending from the first conductive portion 310. However, the position of the coupling member 380 is not limited to the above-described embodiment and may be variously modified in design depending on a frequency of the antenna. For example, the frequency of the antenna may be changed and/or tuned by changing the position of the coupling member 380.

According to an embodiment, the antenna structure may further include a feeding portion 350 and a ground portion 360. According to an embodiment, the feeding portion 350 of the antenna structure may be a point to which power is supplied and may be electrically connected to the antenna carrier 370 via a feeding line 351 so as to transmit current to the antenna carrier 370 and the first conductive portion 310. For example, a transmit/receive (Tx/Rx) terminal of a wireless communication circuit disposed on the antenna carrier 370 may be connected in series with the feeding portion 350 to perform communication. The wireless communication circuit may include any type of element, such as a switch, a resistive element, a capacitive element, an inductive element, or any combination thereof, for selectively providing series coupling with the feeding portion 350. According to an embodiment, the feeding portion 350 of the antenna structure may be in contact with the antenna carrier 370. According to an embodiment, one end of the feeding portion 350 may be connected to the antenna carrier 370, and the other end may be connected to the first printed circuit board 230. For example, the feeding portion 350 may be a clip (e.g., a c-clip) disposed at an edge of the antenna carrier 370 and electrically connected to the first printed circuit board 230. For example, the feeding portion 350 may be a coaxial cable electrically connected to the first printed circuit board 230. For example, the feeding portion 350 may be a portion extending inward from a first side surface (e.g., the first side surface 210c of FIG. 3).

According to an embodiment, the ground portion 360 of the antenna structure may be electrically connected to the antenna carrier 370. According to an embodiment, the ground portion 360 of the antenna structure may be in contact with the antenna carrier 370. According to an embodiment, one end of the ground portion 360 may be connected to the antenna carrier 370, and the other end may be connected to the first printed circuit board 230. For example, the ground portion 360 may be a conductive member such as a clip (e.g., a c-clip), a coaxial cable, a wire, or a screw disposed at an edge of the antenna carrier 370 electrically connected to the first printed circuit board 230.

According to an embodiment, the first antenna pattern 371 may be connected to the coupling member 380, the feeding portion 350, and/or the ground portion 360. For example, referring to FIG. 8, the first antenna pattern 371 connected to the (1-4)^{th} conductive portion 314 may be disposed adjacent to a portion of the (1-1)^{th} side surface 211 and/or the (1-2)^{th}side surface 212. The coupling member 380 may be connected to a portion of the first antenna pattern 371 disposed adjacent to the (1-1)^{th} side surface 211. The feeding portion 350 and the ground portion 360 may be connected to a portion of the first antenna pattern 371 disposed adjacent to the (1-2)^{th} side surface 212. The feeding portion 350 may be a coaxial cable connected to the first antenna pattern 371. The ground portion 360 may be a screw disposed at an edge of the first antenna pattern 371. For example, referring to FIG. 9, the first antenna pattern 371 connected to the (1-2)^{th}conductive portion 312 may be disposed adjacent to a portion of the (1-3)^{th} side surface 213. The coupling member 380 may be connected to a portion of the first antenna pattern 371 disposed adjacent to the (1-3)^{th}side surface 213. The feeding portion 350 may be connected to a portion of the first antenna pattern 371 disposed adjacent to the (1-3)^{th}side surface 213. The feeding portion 350 may be a coaxial cable connected to the first antenna pattern 371. The ground portion 360 may be connected to at least a portion of the first antenna pattern 371 disposed adjacent to at least a portion of the feeding portion 350. The ground portion 360 may be a screw disposed at an edge of the first antenna pattern 371. For example, referring to FIG. 10, the first antenna pattern 371 may be configured as a coupling pattern without grounding, such as the coupling member 380 or the ground portion 360.

According to an embodiment, the first antenna pattern 371 may be a pattern configured to form resonance when coupled with the first conductive portion 310. For example, when the first conductive portion 310 of FIG. 8 corresponds to a first band (low band (LB)), the first antenna pattern 371 may correspond to at least one of a second band (mid band (MB)), a third band (high band (HB)), or a fourth band (ultra-high band (UHB)). For example, when the first conductive portion 310 of FIG. 9 corresponds to the fourth band (ultra-high band (UHB)), the first antenna pattern 371 may correspond to at least one of the first band (low band (LB)), the second band (mid band (MB)), or the third band (high band (HB)). However, the bands of the first conductive portion 310 and the first antenna pattern 371 are not limited to the above-described embodiments, and a combination of the first conductive portion 310 and the first antenna pattern 371 may be variously modified in design depending on a segmentation length of the first conductive portion 310 and a shape of the first antenna pattern 371.

According to an embodiment, referring to FIG. 11, at least a portion of the first antenna pattern 371 may be disposed in a first region 2011 of a rear surface of the housing (e.g., the first rear surface 210b and the second rear surface 220b). According to an embodiment, the feeding portion 350 connected to the first antenna pattern 371 may be disposed in the first region 2011 of the rear surface of the housing (e.g., the first rear surface 210b and the second rear surface 220b).

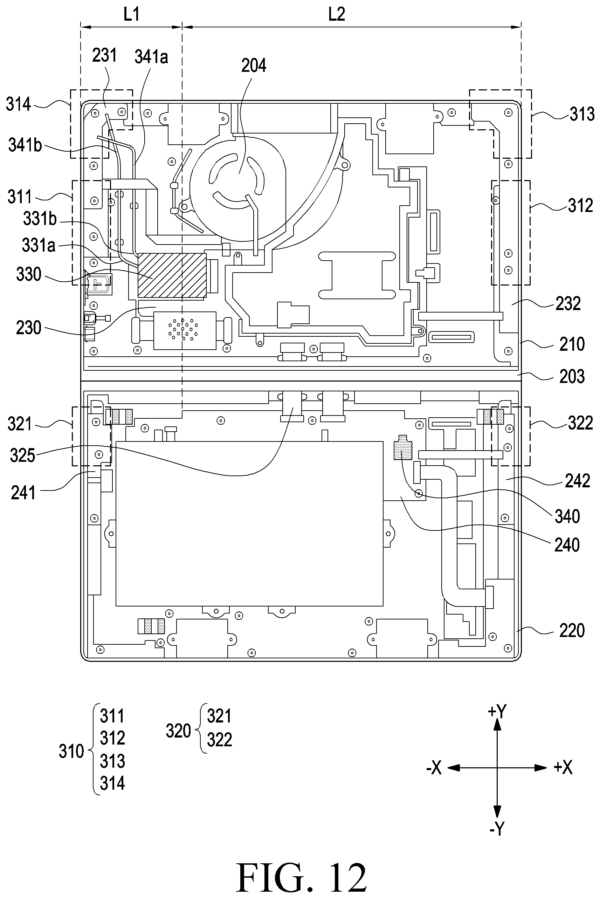

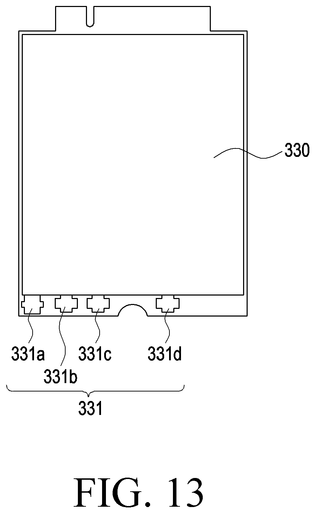

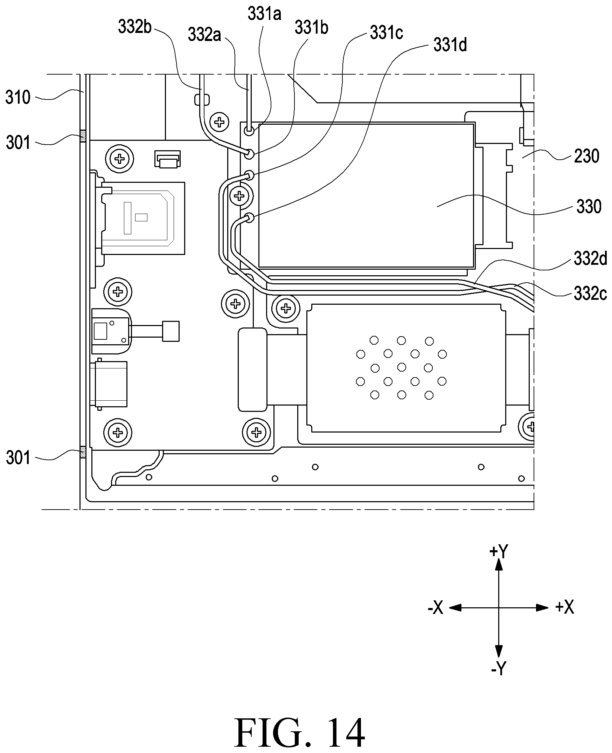

FIG. 12 is a front view illustrating an antenna structure of a first housing, according to an embodiment of the disclosure. FIG. 13 is a view illustrating a first communication module of an electronic device, according to an embodiment of the disclosure. FIG. 14 is a view illustrating the first communication module disposed in an electronic device, according to an embodiment of the disclosure.

Referring to FIGS. 12 to 14, an electronic device 101 may include a foldable housing 201 (hereinafter, referred to as a "housing 201") configured to accommodate components of the electronic device 101, a flexible or foldable display 202 (hereinafter, referred to as a "display 202") disposed in a space formed by the housing 201, a fan 204, and printed circuit boards 230 and 240. The electronic device 101 may further include an antenna structure, and at least one component (e.g., a conductive portion) of the antenna structure may be positioned in one region of the housing 201. The electronic device 101 may further include various components disposed in the housing 201 (e.g., a printed circuit board, a camera module, and a battery).

According to an embodiment, the first communication module 330 may be disposed on one side of the first housing 210 rather than in the central portion of the first housing 210 due to the fan 204 disposed in the central portion of the first housing 210. For example, the first communication module 330 may be disposed on a left side (in the -X-axis direction) or a right side (in the +X-axis direction) relative to the central portion of the first housing 210. However, as the first communication module 330 is disposed on one side, respective first conductive portions 310 disposed along the first side surface 210c of the first housing 210 may have different distances from the first communication module 330, which may cause imbalance in antenna performance. The antenna structure according to the disclosure may reduce variations in antenna performance by limiting antenna types and positions corresponding to the antenna types. However, the above description is not limited to the first communication module 330, and the same may be applied to a case in which the second communication module 340 is disposed in the same housing as the fan 204 or is required to be disposed on one side due to other components disposed in the second housing 220.

According to an embodiment, referring to FIG. 13, the first communication module 330 may include a plurality of first ports 331. For example, the first communication module 330, which is a 5G wireless communication module, may include four or more first ports 331. According to an embodiment, the first ports 331 may include a (1-1)^{th} port 331a, a (1-2)^{th} port 331b, a (1-3)^{th} port 331c, and a (1-4)^{th} port 331d. Each port of the first communication module 330 may be assigned an operating frequency, and a conductive portion connected to a corresponding port may be designed according to the assigned frequency. For example, among frequency bands supported by the first communication module 330, the first band (low band (LB)) may be supported by two ports, and the second band (mid band (MB)), the third band (high band (HB)), and the fourth band (ultra-high band (UHB)) may be supported by all four ports. For example, when the number of antennas configured to radiate radio frequency signals is three, for transmit/receive antennas, the (1-1)^{th} port 331a may support the second band (mid band (MB)), the (1-3)^{th} port 331c may support the fourth band (ultra-high band (UHB)), and the (1-4)^{th}port 331d may support the first band (low band (LB)). For example, when the number of antennas configured to radiate radio frequency signals is two, the (1-1)^{th}port 331a and the (1-4)^{th} port 331d may support all of the first band (low band (LB)), the second band (mid band (MB)), the third band (high band (HB)), and the fourth band (ultra-high band (UHB)), and the (1-2)^{th} port 331b and the (1-3)^{th} port 331c may support all of the second band (mid band (MB)), the third band (high band (HB)), and the fourth band (ultra-high band (UHB)).

According to an embodiment, classification of wavelengths and antenna lengths according to frequency bands is as follows.

For example, the first band (low band (LB)) may be in a frequency range of about 600 MHz to about 1000 MHz. Since the first band operates in a relatively low frequency band, a wavelength thereof may be long, and thus the physical length of a conductive portion (antenna pattern) electrically connected thereto may be longer than those of conductive portions corresponding to the second to fourth bands. However, the frequency bands supported by respective ports are not limited thereto and may be changed depending on whether transmission and/or reception is performed.

For example, the wavelength of the first band (low band (LB)) may range from about 40 cm to about 45 cm, and a length of a connected conductive portion (antenna pattern) may be about 10 cm to about 13 cm. For example, the wavelength of the first band (low band (LB)) may be about 43 cm, and the length of a connected conductive portion (antenna pattern) may be about 11 cm.

For example, the second band (mid band (MB)) may range from about 1700 MHz to about 2100 MHz, a wavelength thereof may range from about 15 cm to about 20 cm, and a length of a connected conductive portion (antenna pattern) may range from about 2 cm to about 6 cm. For example, the second band (mid band (MB)) may be about 1800 MHz, a wavelength thereof may about 17 cm, and a length of a connected conductive portion (antenna pattern) may be about 4 cm.

For example, the third band (high band (HB)) may range from about 2300 MHz to about 2700 MHz, a wavelength thereof may range from about 10 cm to about 15 cm, and a length of a connected conductive portion (antenna pattern) may range from about 2 cm to about 4 cm. For example, the second band (mid band (MB)) may be about 2400 MHz, a wavelength thereof may be about 12.5 cm, and a length of the connected conductive portion (antenna pattern) may be about 3 cm.

For example, the fourth band (ultra-high band (UHB)) may range from about 3000 MHz to about 4000 MHz, a wavelength thereof may range from about 3 cm to about 7 cm, and a length of a connected conductive portion (antenna pattern) may range from about 1 cm to about 2 cm. For example, the second band (mid band (MB)) may be about 3500 MHz, a wavelength thereof may be about 5 cm, and a length of a connected conductive portion (antenna pattern) may be about 1.25 cm.

According to an embodiment, the first communication module 330 electrically connected to the first conductive portion 310 may be disposed on one side of the first housing 210 rather than in the central portion of the first housing 210 due to the fan 204 disposed in the central portion of the first housing 210. For example, the distance between the first communication module 330 and the (1-1)^{th} conductive portion 311 and the (1-4)^{th}conductive portion 314 disposed on the left side of the first housing 210 (in the -X-axis direction) may be shorter than the distance between the first communication module 330 and the (1-3)^{th}conductive portion 313 and the (1-2)^{th} conductive portion 312 disposed on the right side of the first housing 210 (in the +X-axis direction). For example, the (1-1)^{th}conductive portion 311 and the (1-4)^{th} conductive portion 314 may be disposed at a relatively short distance L1 from the first communication module 330, and the (1-3)^{th}conductive portion 313 and the (1-2)^{th} conductive portion 312 may be disposed at a relatively long distance L2 from the first communication module 330.

According to an embodiment, an antenna disposed at a relatively long distance from the first communication module 330 may be used as a first band (low band (LB)) antenna. As a frequency increases, loss depending on the distance from the first communication module 330 may increase. Accordingly, a first band (low band (LB)) antenna having a relatively low frequency may be disposed at a relatively long distance. The distance between the first communication module 330 and the (1-1)^{th}conductive portion 311 (or the (1-4)^{th} conductive portion 314) may be shorter than the distance between the first communication module 330 and the (1-2)^{th} conductive portion 312 (or the (1-3)^{th}conductive portion 313). The length of the (1-1)^{th}conductive portion 311 (or the (1-4)^{th}conductive portion 314) (a first length) may be shorter than the length of the (1-2)^{th}conductive portion 312 (or the (1-3)^{th}conductive portion 313) (a second length).

According to an embodiment, an antenna disposed at a relatively long distance from the first communication module 330 may be used as a transmit/receive antenna and a first band (low band (LB)) antenna. Since a transmission function has better performance than a reception function, a transmit antenna having relatively better performance may be disposed at a relatively long distance.

For example, when the number of antennas configured to radiate radio frequency signals is three, for transmit/receive antennas, the (1-1)^{th} port 331a may support the second band (mid band (MB)), the (1-3)^{th}port 331c may support the fourth band (ultra-high band (UHB)), and the (1-4)^{th} port 331d may support the first band (low band (LB)). For example, the (1-2)^{th}conductive portion 312 disposed at a relatively long distance may support the first band (low band (LB)) and may be connected to the (1-4)^{th} port 331d including transmit and receive functions.

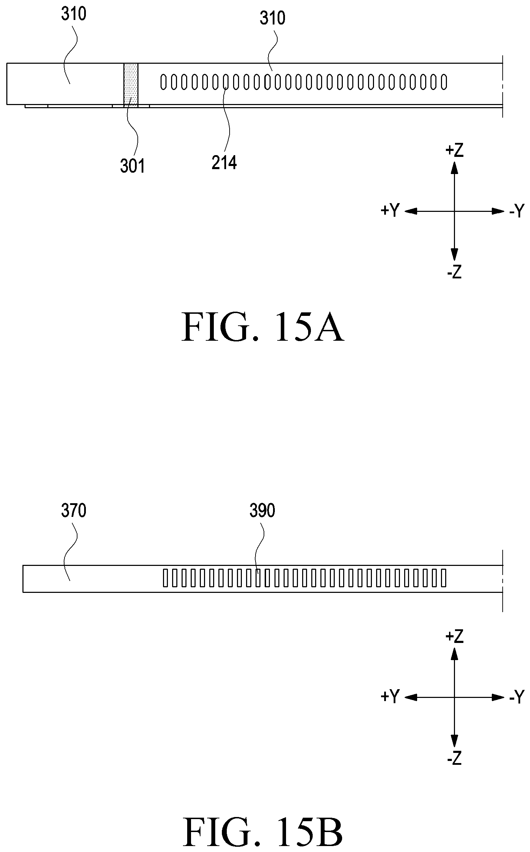

FIG. 15A is a view illustrating a housing in which second vent holes are formed, according to an embodiment of the disclosure. FIG. 15B is a view illustrating an antenna carrier in which first vent holes are formed, according to an embodiment of the disclosure.

Referring to FIGS. 15A and 15B, an electronic device 101 may include a foldable housing 201 (hereinafter, referred to as a "housing 201") configured to accommodate components of the electronic device 101, a flexible or foldable display 202 (hereinafter, referred to as a "display 202") disposed in a space formed by the housing 201, a fan 204, and printed circuit boards 230 and 240. The electronic device 101 may further include an antenna structure, and at least one component (e.g., a conductive portion) of the antenna structure may be positioned in one region of the housing 201. The electronic device 101 may further include various components disposed in the housing 201 (e.g., a printed circuit board, a camera module, and a battery).

According to an embodiment, referring to FIG. 15A, a side surface of the first housing 210 (e.g., the first side surface 210c and the second side surface 220c) may include second vent holes 214. According to an embodiment, referring to FIG. 15B, since at least some of the second vent holes 214 may be blocked by components disposed inside the housing, and in order to reduce interference with airflow through the second vent holes 214, the antenna carrier 370 may include first vent holes 390 on one surface facing the side surface of the housing (e.g., the first side surface 210c and the second side surface 220c). According to an embodiment, the first vent holes 390 and the second vent holes 214 may be arranged to at least partially face each other. By forming the first vent holes 390 in the antenna carrier 370 facing the side surface of the first housing 210 (e.g., the first side surface 210c and the second side surface 220c) so as to correspond to the second vent holes 214, at least some of the second vent holes 214 may be prevented from being blocked by internal components disposed inside the housing.

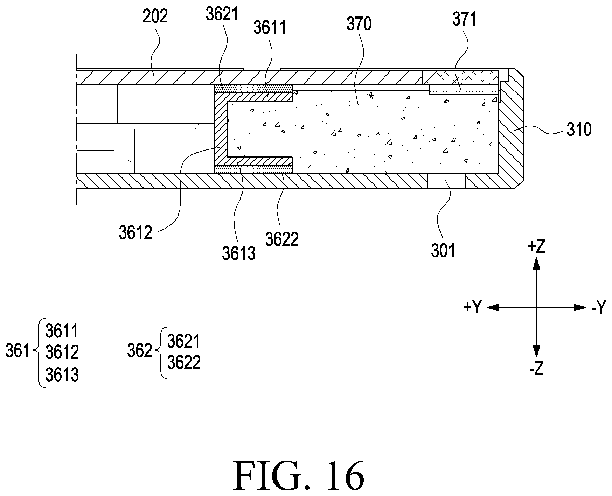

FIG. 16 is a view illustrating an antenna structure including a metal wall, according to an embodiment of the disclosure.

Referring to FIG. 16, an electronic device 101 may include a foldable housing 201 (hereinafter, referred to as a "housing 201") configured to accommodate components of the electronic device 101, a flexible or foldable display 202 (hereinafter, referred to as a "display 202") disposed in a space formed by the housing 201, a fan 204, and printed circuit boards 230 and 240. The electronic device 101 may further include an antenna structure, and at least one component (e.g., a conductive portion) of the antenna structure may be positioned in one region of the housing 201. The electronic device 101 may further include various components disposed in the housing 201 (e.g., a printed circuit board, a camera module, and a battery).

According to an embodiment, a ground portion of the antenna structure (e.g., the ground portion 360 of FIG. 9) may include a metal wall 361. The metal wall 361 may be configured to cause electrons to flow toward the exterior of the electronic device 101 rather than into the interior of the electronic device 101, so that radiation occurs at an edge portion of the electronic device. The metal wall 361 may shield noise. According to an embodiment, the metal wall 361 may include a first portion 3611 in contact with the display 202, a second portion 3612 extending downward (in the -Z-axis direction) from the first portion 3611, and a third portion 3613 extending in a vertical direction from the second portion 3612 and being parallel to the first portion 3611. For example, when viewed from a side, the metal wall 361 may have a " 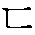 " shape.

According to an embodiment, the metal wall 361 may be electrically connected, via an electrical connection member 362, to the display 202 including metal, a front surface of the housing 201 including metal (e.g., the first front surface 210a and the second front surface 220a), or a rear surface of the housing 201 (e.g., the first rear surface 210b and the second rear surface 220b). According to an embodiment, in order for the housing 201 including metal to operate in a desired frequency band, the metal wall 361 may need to be disposed at a corresponding position of the housing 201, and a separate electrical connection member 362 may be disposed to allow physical contact between at least a portion of the housing 201 and the metal wall 361. According to an embodiment, the electrical connection member 362 may include a first electrical connection member 3621 in contact with a first portion 3611 of the metal wall 361 and a second electrical connection member 3622 in contact with a third portion 3613 of the metal wall 361. For example, the second electrical connection member 3622 may be in contact with a front surface of the housing 201 (e.g., the first front surface 210a and the second front surface 220a), and the first electrical connection member 3621 may be in contact with a rear surface of the housing 201 (e.g., the first rear surface 210b and the second rear surface 220b) and/or at least a portion of the display 202. For example, the electrical connection member 362 may include at least one of a stranded wire cable (e.g., a metal wire), a flexible printed circuit board, a conductive Poron tape, a conductive gasket, or a C-clip conductive tape.

According to an embodiment of the disclosure, an electronic device may include a first housing including at least one first conductive portion 310 segmented along at least a portion of a side surface, an antenna carrier 370 on which a first antenna pattern electrically connected to the first conductive portion 310 is formed, a fan disposed in the first housing, and a first printed circuit board disposed in the first housing and including a first communication module electrically connected to the first conductive portion 310. The antenna carrier 370 may include a first vent hole 390 formed in at least a portion of a side surface, and a feeding portion 350 provided on the first antenna pattern and configured to be electrically connected to the first printed circuit board.

According to an embodiment, the first housing may include a second vent hole 214 formed in at least a portion of the side surface, and the first vent hole and the second vent hole may be disposed to face each other at least partially.

According to an embodiment, a rear surface 210b (FIG. 3) of the first housing may include a first region 2011 (FIG. 4) including a non-metal material, and a second region 2012 (FIG. 4) extending from the first region and including a metal material.

According to an embodiment, the antenna carrier 370 (FIG. 6) may be electrically connected to the first conductive portion through a coupling member 380 (FIG. 6).

According to an embodiment, the coupling member may include either a screw or a hook.

According to an embodiment, the feeding portion may include one of a clip (e.g., a c-clip), a coaxial cable, or a portion extending inward from the side surface.

According to an embodiment, the antenna carrier may further include a ground portion 360 provided on the first antenna pattern and configured to be electrically connected to the first printed circuit board.

According to an embodiment, the ground portion may include one of a clip (e.g., a c-clip), a coaxial cable, a wire, or a screw.

According to an embodiment, the feeding portion may be disposed at a position corresponding to the first region of the rear surface of the first housing.

According to an embodiment, the first conductive portion and the antenna carrier may be configured to operate as a radiator of an antenna.

According to an embodiment, the first conductive portion may be configured to transmit or receive a radio frequency signal.

According to an embodiment, the ground portion may include a metal wall 361 (FIG. 16) including a first portion 3611 (FIG. 16) that is in contact with a flexible display 202 (FIG. 3), a second portion 3612 (FIG. 16) that extends from the first portion in a vertical direction, and a third portion 3613 (FIG. 16) that extends from the second portion in a vertical direction and parallel to the first portion.

According to an embodiment, the electronic device may further include a second housing 220 (FIG. 3) including a second conductive portion 320 (FIG. 3) segmented along at least a portion of a side surface and configured to provide a relative movement with respect to the first housing, a flexible display 202 (FIG. 3) configured to be deformable in response to the relative movement of the second housing with respect to the first housing, and a second printed circuit board 240 (FIG. 4) disposed in the second housing and including a second communication module 340 (FIG. 4) electrically connected to the second conductive portion.

According to an embodiment, the first conductive portion may include a (1-1)^{th} conductive portion 311 (FIG. 5) having a first length, and a (1-2)^{th}conductive portion 312 (FIG. 5) having a second length shorter than the first length, and a distance between the first communication module and the (1-1)^{th}conductive portion may be smaller than a distance between the first communication module and the (1-2)^{th} conductive portion.

According to an embodiment, the (1-2)^{th} conductive portion may be an antenna of a first band (low band (LB)), and the (1-1)^{th} conductive portion may be an antenna having a frequency higher than that of the first band.

According to an embodiment of the disclosure, an electronic device may include a first housing including at least one first conductive portion 310 segmented along at least a portion of a side surface, an antenna carrier 370 on which a first antenna pattern electrically connected to the first conductive portion 310 via a coupling member 380 (FIG. 6) is formed, a fan disposed in the first housing, and a first printed circuit board disposed in the first housing and including a first communication module electrically connected to the first conductive portion 310. The antenna carrier may include a first vent hole 390 formed in at least a portion of a side surface.

According to an embodiment, the antenna carrier may further include a feeding portion 350 provided on the first antenna pattern and configured to be electrically connected to the first printed circuit board.

According to an embodiment, the first housing may include a second vent hole 214 formed in at least a portion of the side surface, and the first vent hole and the second vent hole may be disposed to face each other at least partially.

According to an embodiment, a rear surface 210b (FIG. 3) of the first housing may include a first region 2011 (FIG. 4) including a non-metal material, and a second region 2012 (FIG. 4) extending from the first region and including a metal material.

According to an embodiment, the coupling member may include either a screw or a hook.

The technical problems to be addressed by the disclosure are not limited to those described above, and other technical problems not mentioned above may be clearly understood by a person ordinarily skilled in the related art to which the disclosure pertains.

In general, in an electronic device using a segmented antenna, since side surface segments of a housing are used as antenna patterns, physical constraints may arise. In the case of a high-performance electronic device such as a laptop, the electronic device may include a fan configured to suppress heat generation and vent holes configured to provide convection inside and outside the electronic device. However, when the fan is positioned in a central portion of the electronic device, a communication module may be disposed on one side, and since distances between the antennas and the communication module differ from each other, imbalance in antenna performance may occur.

According to an embodiment of the disclosure, by combining a conductive portion serving as a segmented antenna with an antenna carrier to form a single antenna band, physical constraints of segmented antennas may be reduced, and various frequency bands may be designed. In order to reduce imbalance in antenna performance due to a difference in distance between the antennas and the communication module, antenna arrangement and design may be performed in consideration of the distance difference between the antennas and the communication module.

However, the issues to be addressed by the disclosure are not limited to those described above and may be variously expanded without departing from the spirit and scope of the disclosure.

## Claims

1. An electronic device comprising:
a first housing including at least one first conductive portion (310) segmented along at least a portion of a side surface;
an antenna carrier (370) on which a first antenna pattern electrically connected to the first conductive portion is formed;
a fan disposed in the first housing; and
a first printed circuit board disposed in the first housing and including a first communication module electrically connected to the first conductive portion,
wherein the antenna carrier (370) includes:
a first vent hole (390) formed in at least a portion of a side surface, and
a feeding portion (350) provided on the first antenna pattern and configured to be electrically connected to the first printed circuit board.

2. The electronic device of claim 1, wherein the first housing includes a second vent hole (214) formed in at least a portion of the side surface, and
wherein the first vent hole and the second vent hole are disposed to face each other at least partially.

3. The electronic device of any one of claims 1 and 2, wherein a rear surface (210b of FIG. 3) of the first housing includes a first region (2011 of FIG. 4) including a non-metal material, and a second region (2012 of FIG. 4) extending from the first region and including a metal material.

4. The electronic device of any one of claims 1 to 3, wherein the antenna carrier (370 of FIG. 6) is electrically connected to the first conductive portion via a coupling member (380 of FIG. 6).

5. The electronic device of claim 4, wherein the coupling member includes either a screw or a hook.

6. The electronic device of any one of claims 1 to 5, wherein the feeding portion includes any one of a clip (e.g., a c-clip), a coaxial cable, or a portion extending inward from the side surface.

7. The electronic device of any one of claims 1 to 6, further comprising:
a ground portion (360) provided on the first antenna pattern of the antenna carrier and configured to be electrically connected to the first printed circuit board.

8. The electronic device of claim 7, wherein the ground portion includes one of a clip (e.g., c-clip), a coaxial cable, a wire, or a screw.

9. The electronic device of claim 3, wherein the feeding portion is disposed at a position corresponding to the first region of the rear surface of the first housing.

10. The electronic device of any one of claims 1 to 9, wherein the first conductive portion and the antenna carrier are configured to operate as a radiator of an antenna.

11. The electronic device of any one of claims 1 to 10, wherein the first conductive portion is configured to transmit or receive a radio frequency signal.

12. The electronic device of claim 7, wherein the ground portion includes a metal wall (361 of FIG. 16) including a first portion (3611 of FIG. 16) that is in contact with a flexible display (202 of FIG. 3), a second portion (3612 of FIG. 16) that extends from the first portion in a vertical direction, and a third portion (3613 of FIG. 16) that extends from the second portion in a vertical direction and parallel to the first portion.

13. The electronic device of any one of claims 1 to 12, further comprising:
a second housing (220 of FIG. 3) including a second conductive portion (320 of FIG. 3) segmented along at least a portion of a side surface and configured to provide a relative movement with respect to the first housing;
a flexible display (202 of FIG. 3) configured to be deformable in response to the relative movement of the second housing with respect to the first housing; and
a second printed circuit board (240 of FIG. 4) disposed in the second housing and including a second communication module (340 of FIG. 4) electrically connected to the second conductive portion.

14. The electronic device of any one of claims 1 to 13, wherein the first conductive portion includes a (1-1)^{th} conductive portion (311 of FIG. 5) having a first length, and a (1-2)^{th} conductive portion (312 of FIG. 5) having a second length longer than the first length, and
wherein a distance between the first communication module and the (1-1)^{th} conductive portion is smaller than a distance between the first communication module and the (1-2)^{th} conductive portion.

15. The electronic device of claim 14, wherein the (1-2)^{th}conductive portion is an antenna of a first band (low band (LB)), and
wherein the (1-1)^{th} conductive portion is an antenna having a frequency higher than that of the first band.
